# EUROPEAN PATENT APPLICATION

(11) **EP 0 849 779 A2**
(43) Date of publication of application: **24.06.1998**
(21) Application number: 97310470.6
(22) Date of filing: 22.12.1997
(51) Int. Cl.: H01L 21/306, C23C 16/02, H01L 21/768

(54) **Process for forming a semiconductor structure comprising ion cleaning and depositing steps and integrated cluster tool for performiong the process**

(30) Priority: 20.12.1996 US 33728 P
(71) Applicant: TEXAS INSTRUMENTS INCORPORATED, Dallas Texas 75265 (US)
(72) Inventor: Konecni,Anthony J., Plano Texas 75025 (US); Dixit,Girish A., Plano Texas 75025 (US)
(74) Representative: Darby, David Thomas

(57) **Abstract**

A method for selectively coupling a conductive material (60) to a contact region (32) of a semiconductor device (8) includes bombarding residual material (40) coupled to the contact region (32) with inert ions (44) at a first position associated with an integrated cluster tool (90) to increase the reactive surface area of a residual material (40). Hydrogen ions (46) are introduced at the first position for reaction with the residual material (40) from the contact region (32). The semiconductor device (8) is transferred in situ from the first position to a second position associated with the integrated cluster tool (90). The conductive material (60) is selectively coupled to the contact region (32) at the second position using chemical vapor deposition.

## Description

### TECHNICAL FIELD OF THE INVENTION

This invention relates in general to the field of integrated circuits, and more particularly to a method and system for selectively coupling a conductive material to a surface of a semiconductor device.

### BACKGROUND OF THE INVENTION

Many semiconductor devices include conductive layers interconnected by vias, holes, or other cavities patterned in an oxide or other insulating layer to define contact regions and non-contact regions of the device. Cavitie may be filled with a conductive material to electrically couple the conductive layers according to the design of the semiconductor device. For example, aluminum, copper, titanium, or any other suitable conductive material may be selectively deposited on a contact region after organic compounds, non-conductive native oxides, or other undesirable residual material has been removed from the conductive surface of the contact region to improve the electrical contact between the conductive material and the contact region.

As semiconductor devices become increasingly complex and fabrication requirements become increasingly stringent, removing residual material from surfaces of these devices before selectively depositing a conductive material on these surfaces becomes increasingly important. A known technique for cleaning conductive surfaces includes high power sputter etching to bombard the surfaces with inert gas atoms or ions to physically remove residual material from these surfaces. Although such techniques may be suitable for semiconductor devices with relatively low aspect ratio features that are not topographically sharp, these techniques may not be suitable for devices having topographically sharp features with relatively high aspect ratios, because preferential bombardment may deform these features or redeposit removed material on or near the feature. Furthermore, high ion energies are necessary to achieve adequate bombardment and cleaning at the bottom of these high aspect features. Although lower energy cleaning techniques have used hydrogen to chemically remove residual material in cooperation with physical bombardment, such techniques have not been used in connection with selective sequential in situ chemical vapor deposition of aluminum, copper, titanium, or other conductive materials. Previous cleaning techniques associated with selective coupling processes have involved chlorine or bromine chemistries that are complex, leave behind corrosive by-products and other residue, and use highly corrosive gases that require specialized containment equipment, making such techniques unsuitable for many applications. In addition, these techniques often require further processing and equipment to remove residual material from surrounding non-contact regions after conductive material is coupled to conductive surfaces of the contact regions.

### SUMMARY OF THE INVENTION

In accordance with the present invention, the disadvantages and problems associated with coupling a conductive material to surfaces of a semiconductor device have been substantially reduced or eliminated.

In accordance with one embodiment of the present invention, a method for selectively coupling a conductive material to a contact region of a semiconductor device includes bombarding residual material coupled to the contact region with inert ions at a first position associated with an integrated cluster tool to increase the reactive surface area of the residual material. Hydrogen ions are introduced at the first position for reaction with the residual material to remove the residual material from the contact region. The semiconductor device is then transferred in situ from the first position to a second position associated with the integrated cluster tool, where the conductive material is selectively coupled to the contact region using chemical vapor deposition. In a more particular embodiment the inert ions include helium ions or argon ions and the conductive material includes aluminum, copper, or titanium.

Important technical advantages of the present invention include providing a method and system for selectively coupling a conductive material to a surface of a semiconductor device that uses the chemically reactive properties of hydrogen ions in cooperation with physical bombardment of the surface to wholly or partially remove residual material from the surface prior to selective sequential in situ chemical vapor deposition of a suitable conductive material. In addition, because higher ion energies are not required, the present invention reduces or eliminates the undesirable deformation of high aspect ratio features or topologically sharp features often associated with modern semiconductor devices. Moreover, the present invention is compatible with existing plasma bombardment technology and chemical vapor deposition technology, does not require complex subsequent processing to prepare the surface for selective coupling after cleaning, and does not involve chlorine, bromine, or other corrosive chemistries associated with previous cleaning techniques for selective coupling processes. According to the present invention, and unlike any previous technique, cooperating physical and chemical cleaning processes are used in connection with selective sequential in situ chemical vapor deposition of aluminum, copper, titanium, or other suitable conductive material to electrically interconnect conductive layers of a semiconductor device.

### BRIEF DESCRIPTION OF THE DRAWINGS

For a more complete understanding of the present invention and for further features and advantages thereof, reference is now made to the following description taken in conjunction with the accompanying drawings, in which:
FIGURE 1 illustrates an exemplary integrated cluster tool for cleaning a surface of a semiconductor device and for selective sequential in situ chemical vapor deposition of a suitable conductive material on the surface according to the present invention;
FIGURE 2 illustrates an exemplary apparatus directing a plasma that includes inert ions and hydrogen ions toward surfaces of a semiconductor device according to the present invention;
FIGURE 3 illustrates in detail the exemplary removal of residual material from a surface of a semiconductor device according to the present invention;
FIGURE 4 illustrates an exemplary semiconductor device after removal of a residual material from surfaces of the semiconductor device and selective sequential in situ chemical vapor deposition of a conductive material within cavities of the semiconductor device; and
FIGURE 5 illustrates a method for interconnecting a conductive layer and a contact region associated with a cavity in a semiconductor device.

### DETAILED DESCRIPTION OF THE INVENTION

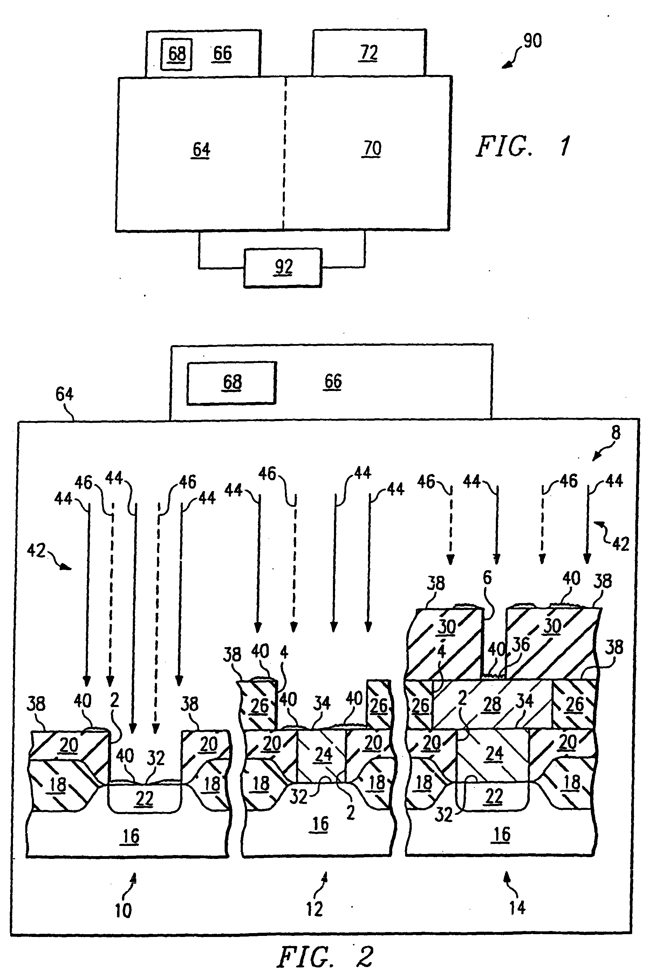

FIGURE 1 illustrates integrated cluster tool 90 for cleaning a surface of a semiconductor device and for selective sequential in situ chemical vapor deposition (CVD), growth, or other suitable coupling of a conductive material to the device surface. Integrated cluster tool 90 includes a chamber 64 that wholly or partially contains the semiconductor device. An appropriate apparatus 66 for bombarding, discharging, or otherwise directing a cleaning plasma toward the semiconductor device and its surfaces is of a conventional type well-known to those of ordinary skill in the art.

In one embodiment, apparatus 66 operates at relatively low power, for example, at a plasma power that is between approximately 150W and 450W and a bias power less than or equal to approximately 300W. In one embodiment, plasma power for apparatus 66 is approximately 250W and bias power for apparatus 66 is approximately 190W, although the present invention contemplates any suitable relatively low power. Apparatus 66 also operates at temperatures of approximately 100°C to 450°C and pressures of approximately 0.1torr to 10torr for approximately five to three hundred seconds. As discussed more fully below with reference to FIGURE 2, apparatus 66 generates ions of hydrogen, argon, nitrogen, or other suitable gases that form the cleaning plasma at flow rates, in standard cubic centimeters (sccm), of approximately 1sccm to 20sccm. In one embodiment, the hydrogen flow rate is approximately 1sccm and the argon flow rate is approximately 4sccm, although the present invention contemplates any suitable flow rates for these ions. A voltage source 68 associated with apparatus 66 may negatively bias chamber 64 or the semiconductor device from approximately -300V to -400V to attract the ions at high velocity for bombardment of the semiconductor device. The present invention contemplates any suitable apparatus 66, chamber 64, and voltage source 68 for directing a cleaning plasma toward surfaces of a semiconductor device.

Integrated cluster tool 90 also includes a chemical vapor deposition chamber 70 and associated apparatus 72 for selective sequential in situ deposition, growth, or other coupling of aluminum, copper, titanium, or any other suitable conductive material within vias, holes, or other cavities of the semiconductor device. In one embodiment, apparatus 72 operates at temperatures between approximately 160°C and approximately 280°C, for example, approximately 200°C. For selective chemical vapor deposition according to the present invention, flow rates for a carrier of the aluminum or other metal to be deposited may range from approximately 50sccm to 500sccm and the diluent flow rate may be less than or equal to approximately 500sccm. In a more particular embodiment, the carrier flow rate and the diluent flow rate are both approximately 100sccm, although any other suitable flow rate may be used without departing from the intended scope of the present invention.

One or more pumps 92 associated with integrated cluster tool 90 maintain chamber 64 at a relatively low or vacuum pressure and remove volatilized and other reaction products from chamber 64 according to the operation of apparatus 66 and cleaning of surfaces of the semiconductor device, as discussed more fully below. Pumps 92 further maintain chamber 70 at a relatively low or vacuum pressure, which in a particular embodiment is approximately 10⁻⁷torr to 10⁻⁸torr. For selective sequential in situ chemical vapor deposition, growth, or coupling of an appropriate conductive material, the semiconductor device is moved or otherwise transferred from chamber 64 to chamber 70 without being exposed to the ambient. In one embodiment, chamber 64 is at a first position and chamber 70 is at a second position, although cleaning of the semiconductor device and coupling of the conductive material to the semiconductor device may occur at a single location associated with integrated cluster tool 90.

FIGURE 2 illustrates exemplary portions 10, 12, and 14 of a typical semiconductor device 8 at various stages of fabrication. Portions 10, 12, and 14 each include one or more contact regions 32 and one or more non-contact regions 38, portions 12 and 14 each additionally include one or more contact regions 34, and portion 14 additionally includes one or more contact regions 36. Portions 10, 12, and 14 represent layered structures that might exist in a typical semiconductor device and are used as examples to illustrate the features and advantages of the present invention. Although portions 10, 12, and 14 are discussed, the present invention contemplates a variety of structures, whether conventional or non-conventional, that may form a portion of or be associated in any other manner with a semiconductor device. In one embodiment, portions 10, 12, and 14 are portions of semiconductor device 8 under assembly, which upon completion will include multiple metallic layers electrically interconnected by conductive materials that fill vias, holes, or other cavities within portions 10, 12, and 14.

For example, portions 10, 12, and 14 may each include a silicon, gallium arsenide, or any other semiconductive substrate 16, a field or other oxide 18 of substrate 16, and an oxide layer 20 patterned in some suitable manner on field oxide 18. Field oxide 18 and oxide layer 20 of portions 10, 12, and 14 include vias, holes, or other cavities 2 that define contact regions 32 and non-contact regions 38 surrounding contact regions 32. Doped regions 22 of substrate 16 that have different electrical characteristics than other regions of substrate 16 may lie beneath contact regions 32. Cavities 2 may be wholly or partially filled with polysilicon, copper, aluminum, tungsten, or any other suitable metallic, non-metallic, or composite conductive material 24. In one embodiment, conductive material 24 includes aluminum that has low resistivity relative to tungsten. Field oxide 18 and oxide layer 20 form an insulating layer that separates conductive materials 24 from other conductive structures or features of semiconductor device 8 in accordance with the design of semiconductor device 8.

As shown in FIGURE 1, portions 12 and 14 include an additional oxide or other insulating layer 26 patterned to form vias, holes, or other cavities 4 that define contact regions 34 and non-contact regions 38 surrounding contact regions 34. Similar to cavities 2, cavities 4 may be filled with polysilicon, copper, aluminum, tungsten, or any other appropriate metallic, non-metallic, or composite conductive material 28 that couples to the conductive surfaces of contact regions 34. Portion 14 includes a third insulating layer 30 formed from an oxide or other suitable material and patterned to form via 6 that defines contact region 36 and non-contact regions 38 surrounding contact region 36. Semiconductor device 8 under assembly may include as many interconnected layers as are necessary or desirable.

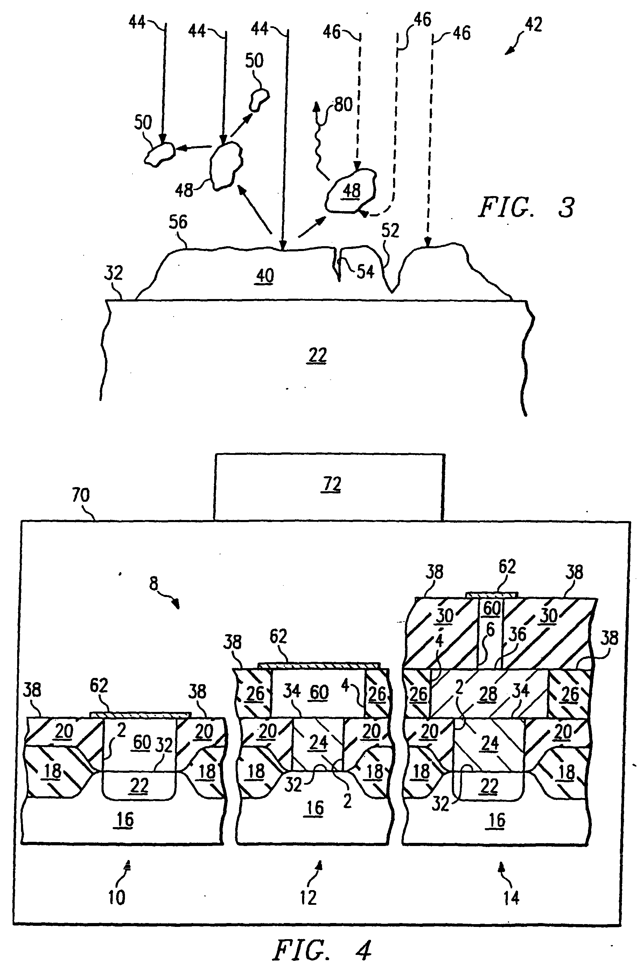

Cavities 2, 4, and 6 are referred to generally as cavity 2, and contact regions 32, 34, and 36 are referred to generally as contact region 32. The present invention contemplates any suitable portion of semiconductor device 8 that includes at least one cavity 2 and an associated contact region 32, non-contact region 38, or other surface from which removal of a residual material is necessary or desirable. After removal of the residual material, as discussed more fully below with reference to FIGURE 4, aluminum, copper, titanium, or another suitable conductive material is selectively deposited, grown, or otherwise coup-led to contact region 32 using a sequential in situ chemical vapor deposition technique to substantially fill cavity 2.

Residual material 40 is coupled to portions of the conductive surface of contact region 32 and portions of the surface of non-contact region 38. Residual material 40 may include any material or materials that are undesirable in any way for fabrication or performance of semiconductor device 8, for example, and not by way of limitation: native or other oxides of silicon, polysilicon, aluminum, copper, titanium, titanium nitride, or other material; polymers, organic compounds, dirt, or other residue remaining after etching or other processing; material resulting from non-selective deposition external to cavity 2 or transported from the interior to the exterior of cavity 2 during processing; chemicals or other corrosive residue remaining after wet etching or other wet processing; or any other undesirable material or materials that may couple to a surface of semiconductor device 8. In one embodiment, residual material 40 coupled to contact region 32 reduces electrical conductivity through the conductive surface of contact region 32. Residual material 40 coupled to contact region 32 or non-contact regions 38 hinders selective deposition, growth, or coupling of desirable conductive materials on these surfaces. As discussed below, the present invention provides for removal of residual material 40 from surfaces of semiconductor device 8 to allow for selective sequential in situ chemical vapor deposition, growth, or other coupling of aluminum, copper, titanium, or any other suitable conductive material within cavity 2 while reducing or eliminating non-selective deposition of the conductive material external to cavity 2.

As shown in FIGURE 2, apparatus 66 of integrated cluster tool 90 directs a plasma 42 toward surfaces of semiconductor device 8 within chamber 64 such as exposed contact regions 32, 34, and 36, respectively, and exposed non-contact regions 38. As discussed above with reference to FIGURE 1, voltage source 68 may negatively bias chamber 64 and semiconductor device 8 from approximately -300V to -400V to attract ions at high velocity for bombardment of surfaces of semiconductor device 8, such as contact region 32 and non-contact regions 38. Plasma 42 includes inert ions, as indicated by solid arrows 44, and hydrogen ions, as indicated by dashed arrows 46. Inert ions 44 may include argon, helium, or any other inert ions, in any appropriate combination, that bombard residual material 40 to roughen, dislodge, or otherwise increase the reactive surface area of residual material 40. Hydrogen ions 46 in plasma 42 react with residual material 40 according to a reduction or other suitable chemical reaction. Pumps 92 remove volatilized and other reaction products from chamber 64 to substantially eliminate residual material 40 from association with semiconductor device 8. Inert ions 44 and hydrogen ions 46 cooperate to physically and chemically remove some or all residual material 40 from the surface of contact region 32, non-contact region 38, or the walls of cavity 2, in any suitable combination.

During operation of apparatus 66, inert ions 44 such as argon or helium gain momentum sufficient to roughen, pit, dislodge, or otherwise alter the physical structure of residual material 40 upon bombarding residual material 40. In addition to possible physical removal of residual material 40 from contact region 32, non-contact region 38, or other surfaces of semiconductor device 8, bombardment of residual material 40 with inert ions 44 increases the reactive surface area of residual material 40 accessible to hydrogen ions 46. In one embodiment, inert ions 44 do not react chemically with residual material 40 or with the surfaces of contact region 32 or non-contact region 38. Although plasma 42 containing nitrogen may react with surfaces of semiconductor device 8 to form nitrides, the stoichiometric or non-stoichiometric nitrides formed are generally conductive and do not significantly reduce electrical performance of the device.

Due to cooperating physical and chemical actions of inert ions 44 and hydrogen ions 46, respectively, apparatus 66 removes residual material 40 despite the relatively low energy of inert ions 44, providing an important technical advantage. Apparatus 66 directs inert ions 44 toward the surface of semiconductor device 8 at a lower velocity and with less momentum than particles used in higher power sputter etching processes. Physical bombardment of the surface therefore causes less deformation of high aspect ratio features or other topologically sharp features. For example, cavity 2 may be a high aspect ratio feature having relatively sharp edges that are subject to preferential bombardment during conventional high power sputter etching processes. Moreover, bombarding residual material 40 with inert ions 44 having relatively low energy may reduce or eliminate resputtering or other non-selective deposition on non-contact regions 38 external to cavity 2. In addition, cooperating physical and chemical processes of the present invention reduce or eliminate the need for subsequent cleaning processes that are complex, equipment-intensive, and often associated with undesirable chlorine, bromine, or other corrosive chemistries. The cleaning technique of the present invention provides an important technical advantage when used in connection with selective sequential in situ chemical vapor deposition, growth, or other coupling of a conductive material to contact region 32.

FIGURE 3 illustrates in detail the removal of residual material 40 from an exemplary surface of semiconductor device 8, for example, the surface 56 of contact region 32. Inert ions 44 of plasma 42 bombard residual material 40 to roughen, pit, dislodge, or otherwise alter the physical structure of residual material 40 to increase the reactive surface area of residual material 40 accessible to hydrogen ions 46 of plasma 42. For example, inert ions 44 may bombard surface 56 to form dislodged fragments 48 of residual material 40, sub-fragments 50 of residual material 40 formed as a result of bombarding dislodged fragments 48, pits 52 or fissures 54 in surface 56, roughening of surface 56, or any other physical structures or features that increase the reactive surface area of residual material 40 accessible to hydrogen ions 46. In one embodiment, due to the small size of inert ions 44, fragments 48 may be formed from one or more atoms, molecules, or other relatively minute particles of residual material 40.

More or less simultaneous to inert ions 44 increasing the reactive surface area of residual material 40, hydrogen ions 46 react with residual material 40 in a reduction or other appropriate chemical reaction to remove residual material 40 from surface 56. System 8 pumps or otherwise removes the volatilized and other reaction products from surface 56, as indicated by arrow 80. The cooperating actions of inert ions 44 and hydrogen ions 46 leave surface 56 cleaner than before and more suitable for selective sequential in situ chemical vapor deposition, growth, or other coupling of aluminum, copper, titanium, or another suitable conductive material.

Increasing the reactive surface area of residual material 40 accessible to hydrogen ions 46 increases the speed and effectiveness with which hydrogen ions 46 chemically reduce residual material 40 to remove residual material 40. Although hydrogen ions 46 are capable of reacting with exposed surface 56 of residual material 40 without bombardment of residual material 40 with inert ions 44, simultaneously bombarding residual material 40 with inert ions 44 significantly increases the effectiveness of the chemical cleaning process associated with hydrogen ions 46. In addition, cleaning of surface 56 according to the present invention reduces or eliminates the undesirable deformation of topologically sharp features or high aspect ratio features associated with surface 56, such as edges of cavity 2 associated with contact region 32. Furthermore, the cleaning technique of the present invention is compatible with existing technology, reduces resputtering or other non-selective deposition external to cavity 2, does not require complex subsequent processing to prepare surfaces for material deposition, and does not involve highly corrosive chlorine, bromine, or other chemistries associated with previous techniques used in connection with selective coupling of conductive materials.

FIGURE 4 illustrates portions 10, 12, and 14 of semiconductor device 8 after residual material 40 has been removed from contact regions 32, 34, and 36, respectively, and non-contact regions 38. Semiconductor device 8 has been transferred from chamber 64 of integrated cluster tool 90 to chamber 70 of integrated cluster tool 90 without exposure to the ambient to allow for selective sequential in situ chemical vapor deposition, growth, or coupling of a conductive material 60 to exposed contact regions 32, 34, and 36. Conductive material 60 may be formed from aluminum, copper, titanium, or any other suitable material or combination of materials. Conductive material 60 is deposited, grown, or otherwise coupled to the surface of contact region 32 to substantially fill cavity 2. The present invention contemplates removing residual material 40 and coupling conductive material 60 to semiconductor device 8 at a single location associated with integrated cluster tool 90.

After selective coupling of conductive material 60 to exposed contact regions 32, 34, and 36, a conductive layer 62 formed from an alloy of aluminum, copper, titanium, or any other suitable metallic, non-metallic, or composite conductive material is coupled to conductive material 60, non-contact regions 38, or both conductive material 60 and non-contact regions 38 according to a blanket deposition or other suitable technique. In one embodiment, conductive layer 62 includes an alloy of aluminum that contains up to approximately two percent copper. Residual material 40 may be removed from conductive material 60, non-contact regions 38, or both conductive material 60 and non-contact regions 38 in the manner discussed above before coupling of conductive layer 62.

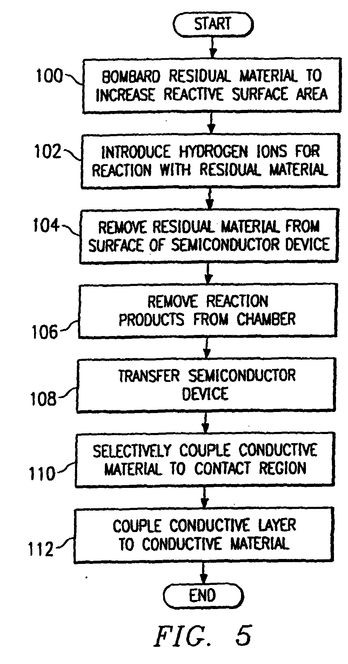

FIGURE 5 is a flow chart illustrating an exemplary method for interconnecting conductive layer 62 and contact region 32 associated with cavity 2 in semiconductor device 8. The method begins at step 100, where residual material 40 is bombarded with inert ions 44 to increase the reactive surface area of residual material 40 accessible to hydrogen ions 46. At step 102, hydrogen ions 46 react with residual material 40 to remove residual material 40 from the surface of the integrated circuit. Although the activities of inert ions 44 and hydrogen ions 46 are discussed as occurring sequentially, the present invention contemplates steps 100 and 102 occurring simultaneously as a sputter etching process using apparatus 66 or in any other suitable manner. Volatile and other reaction products associated with residual material 40 are wholly or partially removed from contact region 32, non-contact region 38, or any other surfaces of semiconductor device 8 at step 104. At step 106, integrated cluster tool 90 and pumps 92 remove these substances from chamber 64 using negative pressure, a charge gradient, or in any other suitable manner. At this point, cleaning of semiconductor device 8 according to the present invention is substantially complete.

At step 108, semiconductor device 8 is transferred in situ to chamber 70 of integrated cluster tool 90 for coupling of conductive material 60 to exposed contact region 32 at step 110. Conductive material 60 may be selectively deposited, grown, or otherwise coupled to contact region 32 using a chemical vapor deposition or other suitable technique to substantially fill cavity 2. Conductive material 60 may include aluminum, copper, titanium, or any other suitable material or composition, in any combination. At step 112, conductive layer 62 may be coupled to conductive material 60 using a blanket deposition or other suitable technique to electrically interconnect conductive layer 62 and contact region 32, and the method ends. In one embodiment, conductive layer 62 includes an aluminum alloy having up to approximately two percent copper. Further processing of semiconductor device 8 may occur according to particular needs.

Although the present invention has been described above in connection with several embodiments, it should be understood that a plethora of changes, substitutions, variations, alterations, transformations, and modifications may be suggested to one skilled in the art, and it is intended that the present invention encompass such changes, variations, substitutions, alterations, transformations, and modifications as fall within the spirit and scope of the appended claims.

## Claims

1. A method for selectively coupling a conductive material to a contact region of a semiconductor device, comprising:
bombarding residual material coupled to the contact region with inert ions at a first position to increase the reactive surface area of the residual material;
introducing hydrogen ions at the first position for reaction with the residual material to remove the residual material from the contact region;
transferring the semiconductor device in situ from the first position to a second position associated with the integrated cluster tool; and
selectively coupling the conductive material to the contact region at the second position using chemical vapor deposition.

2. The method of Claim 1, wherein the step of bombarding comprises bombarding the residual material with inert ions selected from a group of materials consisting of:
helium ions and argon ions.

3. The method of Claim 1 or Claim 2, wherein the step of bombarding comprises bombarding the residual material with inert ions that are to roughen the surface of the residual material.

4. The method of any preceding Claim 4, further comprising selecting the residual material from a group of material consisting of:
an oxide of aliminum; an oxide of copper; and an oxide of titanium.

5. The method of any preceding Claim 4, further comprising:
negatively biasing the semiconductor device to attract the inert ions for bombardment of the contact region.

6. The method of preceding Claim, further comprising selecting the conductive material from a group of material consisting of:
aluminum; copper; and titanium.

7. The method of any preceding Claim, wherein the step of selectively coupling comprises substantially filling a cavity associated with the contact region with said conductive material.

8. The method of any preceding Claim, further comprising performing bombarding and the step of introducing hydrogen ions at approximately the same time.

9. The method of any preceding Claim, further comprising transferring the semiconductor device from the first position to the second position without being exposed to the ambient.

10. A method for interconnecting a conductive layer and a contact region associated with a cavity in a semiconductor device, the method comprising:
bombarding the contact region with inert ions at a first position to increase the reactive surface area of residual material coupled to the contact region;
introducing hydrogen ions at the first position for reaction with the residual material to remove the residual material from the contact region;
transferring the semiconductor device in situ from the first position to a second position associated with the integrated cluster tool; and
coupling a conductive material to the contact region using selective chemical vapor deposition to substantially fill the cavity; and
coupling the conductive layer to the conductive material to interconnect the conductive layer and the contact region.

11. The method of Claim 10, wherein the step of coupling the conductive layer to the conductive material comprises blanket depositing an alloy of the conductive material on the conductive material.

12. The method of Claim 10 or Claim 11 further comprising transferring the semiconductor device from the first position to the second position without being exposed to the ambient.

13. The method of any of Claims 10 to 12, wherein the step of bombarding comprises bombarding the residual material with inert ions that are adapted to roughen the surface of the residual material.

14. The method of any of Claims 10 to 13, further comprising selecting the conductive material from a group of material consisting of:
aluminum; copper; and titanium.

15. The method of any of Claims 10 to 14, further comprising performing the step of bombarding and the step of introducing hydrogen ions at approximately the same time.

16. An integrated cluster tool for selectively coupling a conductive material to a contact region of a semiconductor device, comprising:
a first low pressure chamber for containing the semiconductor device at a first position;
a first apparatus for directing a plasma toward the contact region at the first position, the plasma comprising inert ions and hydrogen ions, the inert ions adapted to increase the reactive surface area of residual material coupled to the contact region, the hydrogen ions adapted to react with the residual material to remove the residual material from the contact region;
a second low pressure chamber for containing the semiconductor device at a second position; and
a second apparatus for selectively coupling the conductive material to the contact region at the second position using chemical vapor deposition.

17. The integrated cluster tool of Claim 16, wherein the conductive material is selected from a group of materials consisting of:
aluminum; copper; and titanium.

18. The integrated cluster tool of Claim 16 or Claim 17, further comprising a voltage source associated with the first apparatus and operable to negatively bias semiconductor device to approximately -300V to -400V for attraction of the inert ions.

19. The integrated cluster tool of any of Claims 16 to 18, wherein the integrated cluster tool is operable to maintain the first chamber at a pressure of approximately 0.1 to 10 torr and to maintain the second chamber at a pressure of approximately 10⁻⁷ to 10⁻⁸ torr.

20. The integrated cluster tool of any of Claims 16 to 19, wherein the integrated cluster tool is operable to transfer the semiconductor device from the first position to the second position without being exposed to the ambient.
